# EUROPÄISCHE PATENTSCHRIFT

(11) **EP 1 100 647 B1**
(45) Veröffentlichungstag und Bekanntmachung des Hinweises auf die Patenterteilung: **08.10.2003**
(21) Anmeldenummer: 99942750.3
(22) Anmeldetag: 01.07.1999
(51) Int. Cl.: B23K 26/00

(54) **VORRICHTUNG ZUM LASERBEARBEITEN VON FLACHEN WERKSTÜCKEN**
DEVICE FOR THE LASER PROCESSING OF FLAT WORKPIECES
DISPOSITIF POUR L'USINAGE AU LASER DE PIECES PLATES

(30) Priorität: 14.07.1998 DE 19831558
(43) Veröffentlichungstag der Anmeldung: 23.05.2001
(73) Patentinhaber: SIEMENS AKTIENGESELLSCHAFT, 80333 München (DE)
(72) Erfinder: MÜLLER, Lothar, D-69124 Heidelberg (DE); METZ, Daniel, D-76870 Kandel (DE); DIETRICH, Stefan, D-76185 Karlsruhe (DE)
(86) Internationale Anmeldenummer: DE9901932
(87) Internationale Veröffentlichungsnummer: WO00003830

(56) Entgegenhaltungen:
- EP-A- 0 606 928
- GB-A- 2 332 637
- US-A- 4 328 410
- US-A- 4 730 819

## Beschreibung

Die Erfindung bezieht sich auf eine Vorrichtung zum Laserbearbeiten von zumindest einem plattenartigen flachen Werkstück, insbesondere einer elektrischen Leiterplatte im Arbeitsbereich zumindest einer Lasereinheit, die einen ablenkbaren fokussierten Laserstrahl erzeugt, wobei ein Bearbeitungsbereich des Werkstücks im Ablenkbereich der Lasereinheit positionierbar ist.

Es ist üblich, flächige Werkstücke mittels eines ablenkbare Laserstrahls zu beschriften, wobei das Werkstück in den Strahlungsbereich einer Lasereinheit transportiert wird und wobei die Leiterplatte auf einem Arbeitstisch aufliegt. Insbesondere bei größeren Leiterplatten oder zu einem großen Nutzen zusammengefaßte kleine Leiterplatten weisen Durchbiegungen auf, die eine genaue Fokussierung des Laserstrahls auf die Oberfläche der Leiterplatte erschweren.

Eine Vorrichtung zum Laserbearbeiten von einer elektrischen leiterplatte ist aus GB-A-2 332 637 bekannt.

Der Erfindung liegt die Aufgabe zugrunde, die Bearbeitungsgenauigkeit der Vorrichtung zu erhöhen.

Diese Aufgabe wird durch die Erfindung gemäß Anspruch 1 gelöst. Durch das Einspannen des Werkstückträgers in einem engen Arbeitsbereich ist es möglich, die krümmungsbedingten Abstandabweichungen weitgehend auszuschalten, wobei das Werkstück von der Transporteinrichtung völlig gelöst wird und in einer geeigneten Höhe gehalten wird.

Durch eine Weiterbildung der Erfindung gemäß Anspruch 2 kann die Höhenlage des Werkstücks ohne besonderen Steuerungsaufwand eingestellt werden.

Durch die Weiterbildung nach Anspruch 3 kann die zu bearbeitende Oberfläche des Werkstückes genau auf den Fokus des Laserstrahls eingestellt werden, ohne daß dabei Dickentoleranzen des Werkstücks eine Rolle spielen.

Durch die Weiterbildung nach Anspruch 4 können die durch Dikkenunterschiede bedingten Lageabweichungen der Werkstücke erheblich verringert werden.

Im folgenden wird die Erfindung anhand eines in der Zeichnung dargestellten Ausführungsbeispiels näher erläutert.
- Figur 1: zeigt schematisiert eine Seitenansicht einer Vorrichtung zum Laserbearbeiten von flachen Werkstükken,
- Figur 2: die Einrichtung nach Figur 1 während einer Bearbeitungsphase,
- Figur 3: eine Draufsicht auf die Einrichtung nach Figur 1.

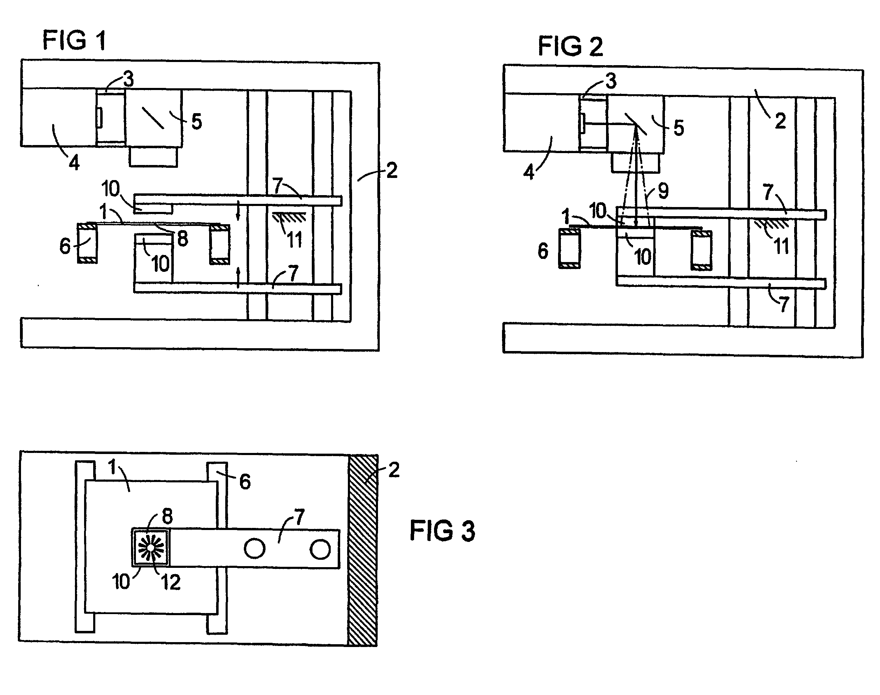

Nach den Figuren 1, 2 und 3 besteht eine Einrichtung zum Laserbearbeiten von flachen Werkstücken 1 aus einem rahmenartigen Träger 2 für eine Lasereinheit 3, die sich aus einem Laserstrahlerzeuger 4 und einer Ablenkeinrichtung 5 zusammensetzt. Am Träger 2 sind außerdem eine Transporteinrichtung 6 und eine Halteeinrichtung 7 verankert.

Die Transporteinrichtung 6 verfährt das Werkstück 1 in eine Stellung, in der ein Bearbeitungsbereich 8 in den Ablenkbereich 9 der Lasereinheit 3 verfahrbar ist, wobei das Werkstück 1 zwischen geöffnete Klemmbacken 10 der Halteeinrichtung 7 gelangt. Diese sind in einer zur Werkstückebene senkrechten Richtung verstellbar und werden, wie in Figur 2 dargestellt, gegen das Werkstück verfahren. Auf der der Lasereinheit 3 zugewandten Seite ist dabei z.B. durch einen Anschlag 11 sichergestellt, daß diese Klemmbacke 10 eine gleichbleibende Höhenlage einnimmt, derart, daß das Werkstück 1 durch die andere Klemmbacke von der Transporteinrichtung 6 zumindest geringfügig abgehoben wird.

Das Werkstück 1 ist nun lediglich zwischen den beiden Klemmbacken fixiert und gehalten. Die rahmenförmig ausgebildeten Klemmbacken 10 umgreifen den verhältnismäßig kleinen Ablenkbereich 9 des Laserstrahls in engem Abstand, wodurch die Einspannfläche klein bleibt und Wölbungen im Werkstück 1 vernachlässigbar werden. Die vom Laserstrahl zu strukturierende Fläche kann dadurch in einer genauen Höhenlage festgelegt werden, so daß auch sehr schmale Leiterbahnen 12 erzeugt werden können.

## Patentansprüche

1. Vorrichtung zum Laserbearbeiten von zumindest einem plattenartigen flachen Werkstück (1), insbesondere einer elektrischen Leiterplatte im Arbeitsbereich zumindest einer Lasereinheit (3), die einen ablenkbaren fokussierten Laserstrahl erzeugt,
wobei ein Bearbeitungsbereich (8) des Werkstücks (1) im Ablenkbereich (9) der Lasereinheit (3) positionierbar ist,
**dadurch gekennzeichnet,**
**daß** der Bearbeitungsbereich (8) mittels einer Transporteinrichtung (6) in den Greifbereich einer Halteeinrichtung (7) für das Werkstück (1) transportierbar ist,
**daß** die Halteeinrichtung (7) zangenartige Klemmbacken (10) aufweist, die zu beiden Seiten des Werkstücks (1) auf dieses aufsetzbar und im Ablenkbereich (9) der Lasereinheit (3) positionierbar sind,
**daß** die Halteeinrichtung (7) das Werkstück (1) von der Transporteinrichtung (6) abhebt,
**daß** am Werkstück (1) anlegbare Klemmflächen der Klemmbacken (10) im und/oder knapp außerhalb des Ablenkbereichs (9) des Laserstrahls angeordnet sind,
**daß** zumindest eine der Klemmbacken (10) eine Freimachung für den Laserstrahl aufweist und
**daß** die Klemmbacken (10) auf eine definierte Höhenlage einstellbar sind.

2. Vorrichtung nach Anspruch 1,
**dadurch gekennzeichnet,**
**daß** eine der Klemmbacken (10) das Werkstück (1) gegen die in ihrer Höhenlage fixierte andere Klemmbacke (10) drückt.

3. Vorrichtung nach Anspruch 1 oder 2,
**dadurch gekennzeichnet,**
**daß** die Lasereinheit (3) und die höhenfixierbare Klemmbacke (10) auf der gleichen Seite des Werkstücks, insbesondere auf dessen Oberseite angeordnet sind.

4. Vorrichtung nach einem der vorhergehenden Ansprüche, **dadurch gekennzeichnet,**
**daß** zu beiden Seiten des Werkstücks (1) Lasereinheiten zur gleichzeitigen Bearbeitung beider Werkstückseiten angeordnet sind und
**daß** die Klemmbacken (10) in ihrer Höhenlage derart verstellbar sind, daß die Mittelebene des Werkstücks (1) auf eine definierte Höhenlage zentrierbar ist.

## Claims

1. Apparatus for the laser machining of at least one plate-like flat workpiece (1), in particular an electrical printed circuit board, in the working area of at least one laser unit (3), which produces a deflectable focused laser beam, in which case a region (8) to be machined of the workpiece (1) can be positioned in the deflecting region (9) of the laser unit (3), **characterized in that** the region (8) to be machined can be transported by means of a transport device (6) into the gripping region of a holding device (7) for the workpiece (1), **in that** the holding device (7) has pincer-like clamping jaws (10) which can be placed in position on the workpiece (1) on both sides of the latter and can be positioned in the deflecting region (9) of the laser unit (3), **in that** the holding device (7) lifts the workpiece (1) from the transport device (6), **in that** clamping surfaces, which can be brought to bear against the workpiece (1), of the clamping jaws (10) are arranged in and/or just outside the deflecting region (9) of the laser beam, **in that** at least one of the clamping jaws (10) has an aperture for the laser beam, and **in that** the clamping jaws (10) can be set to a defined vertical position.

2. Apparatus according to Claim 1, **characterized in that** one of the clamping jaws (10) presses the workpiece (1) against the other clamping jaw (10) fixed in its vertical position.

3. Apparatus according to Claim 1 or 2, **characterized in that** the laser unit (3) and the clamping jaw (10) which can be vertically fixed are arranged on the same side of the workpiece, in particular on its top side.

4. Apparatus according to one of the preceding claims, **characterized in that** laser units for the simultaneous machining of both workpiece sides are arranged on both sides of the workpiece (1), and **in that** the clamping jaws (10) are adjustable in their vertical position in such a way that the centre plane of the workpiece (1) can be centred at a defined vertical position.

## Revendications

1. Dispositif destiné à l'usinage au laser de au moins une pièce plane (1) à forme de carte, notamment une carte à circuits imprimés électriques, dans la zone d'usinage de au moins une unité laser (3), qui génère un rayon laser, focalisé et qui peut être défléchi,
une zone d'usinage (8) de la pièce (1) pouvant être positionnée dans la zone de déflexion (9) de l'unité laser (3),
**caractérisé par le fait**
**que** la zone d'usinage (8) peut être transportée, au moyen d'un dispositif de transport (6), dans la zone de saisie d'un dispositif de retenue (7) pour la pièce (1),
**que** le dispositif de retenue (7) comporte des mâchoires de serrage (10) à forme de pinces, qui peuvent être appliquées sur la pièce (1) sur ses deux côtés et qui peuvent être positionnées dans la zone de déflexion (9) de l'unité laser (3),
**que** le dispositif de retenue (7) soulève la pièce (1) du dispositif de transport (6),
**que** des surfaces de serrage des mâchoires (10), qui peuvent être appliquées sur la pièce (1), sont disposées dans et/ou juste à côté de la zone de déflexion (9) du rayon laser,
**que** au moins une des mâchoires de serrage (10) comporte un espace libre pour le rayon laser et
**que** les mâchoires de serrage (10) peuvent être réglées sur une position en hauteur définie.

2. Dispositif selon la revendication 1
**caractérisé par le fait**
**que** l'une des mâchoires de serrage (10) appuie la pièce (1) contre l'autre mâchoire de serrage (10), laquelle est fixée dans sa position en hauteur.

3. Dispositif selon la revendication 1 ou 2
**caractérisé par le fait**
**que** l'unité laser (3) et les mâchoires de serrage (10), qui peuvent être positionnées en hauteur, sont disposées du même côté de la pièce, en particulier du côté de sa face supérieure.

4. Dispositif selon l'une des revendications précédentes
**caractérisé par le fait**
**que**, des deux côtés de la pièce (1), sont disposées des unités laser destinées à l'usinage simultané des deux côtés de la pièce et
**que** les mâchoires de serrage (10) sont réglables dans leur position en hauteur de telle sorte que le plan milieu de la pièce (1) peut être centré sur une position en hauteur définie.
